# EUROPÄISCHE PATENTSCHRIFT

(11) **EP 1 393 532 B1**
(45) Veröffentlichungstag und Bekanntmachung des Hinweises auf die Patenterteilung: **04.01.2006**
(21) Anmeldenummer: 02729891.8
(22) Anmeldetag: 15.05.2002
(51) Int. Cl.: H04M 1/02, H05K 7/20, H05K 5/02

(54) **ELEKTRONISCHES GERÄT**
ELECTRONIC DEVICE
APPAREIL ELECTRONIQUE

(30) Priorität: 06.06.2001 DE 10127358
(43) Veröffentlichungstag der Anmeldung: 03.03.2004
(73) Patentinhaber: SIEMENS AKTIENGESELLSCHAFT, 80333 München (DE)
(72) Erfinder: PRANGE, Stefan, 81476 München (DE)
(86) Internationale Anmeldenummer: PCT/DE2002/001747
(87) Internationale Veröffentlichungsnummer: WO 2002/100143

(56) Entgegenhaltungen:
- DE-C- 4 307 902
- US-A- 3 200 881
- US-A- 4 646 202

## Beschreibung

Die Erfindung betrifft ein elektronisches Gerät, insbesondere ein Mobiltelefon, mit Prozessoreinrichtung und ein-Gehäuse.

Die rasante technische Entwicklung auf dem Gebiet der Konsumelektronik hat in den letzten Jahren zur Entwicklung und Bereitstellung einer Vielzahl verschiedener elektronischer Geräte geführt, deren Steuerung durch eine Prozessoreinrichtung realisiert ist.

Dabei ist es erstens bekannt, die Kühlung der Prozessoreinrichtung durch mit der Prozessoreinrichtung verbundene Kühlrippen, welche eine vergrößerte Oberfläche aufweisen, oder durch entsprechende Lüftungseinrichtungen zu realisieren. Dies hat insbesondere bei tragbaren Geräten den Nachteil, daß derartige Lösungen einen erhöhten Platzbedarf aufweisen.

Außerdem ist es bekannt, den Wünschen der Konsumenten nach individualisierten Geräten entgegenzukommen, indem diese mit auswechselbaren Gehäuseelementen angeboten werden, wodurch eine Individualisierung des Gerätes hinsichtlich Farbe oder Form nach den Wünschen der Konsumenten ermöglicht wird. Nachteilig daran ist der erhöhte mechanische Aufwand, der zudem zu schwereren und teureren Geräten führt.

Der Erfindung liegt daher insbesondere die Aufgabe zugrunde, ein elektronisches Gerät mit einer elektronischen Schaltung, die Wärme durch Verlustleistung generiert, insbesondere mit einer Prozessoreinrichtung, anzugeben, welches erstens eine Kühlung der elektronischen Schaltung und zweitens eine Individualisierung des Gerätes mit einfachen Mitteln ermöglicht.

Diese Aufgabe wird durch die Merkmale des unabhängigen Anspruchs 1 gelöst. Vorteilhafte und zweckmäßige Weiterbildungen ergeben sich aus den abhängigen Ansprüchen.

Erfindungsgemäß wird also das elektronische Gerät mit einer inneren Gehäuseschale, die die elektronische Schaltung zumindest teilweise umgibt oder bedeckt, und mit einer äußeren Gehäuseschale, die die innere Gehäuseschale zumindest teilweise umgibt oder bedeckt, versehen, wobei das Material der inneren Gehäuseschale und der äußeren Gehäuseschale flüssigkeitsdicht ist. Die innere und die äußere Gehäuseschale sind derart angeordnet und ausgestaltet, daß sie einen flüssigkeitsdichten Hohlraum bilden, der zumindest teilweise mit einer Flüssigkeit gefüllt ist.

Durch die Befüllung des Hohlraumes mit einer Flüssigkeit, die in der Regel eine gegenüber Luft erhöhte Wärmekapazität und Wärmeleitfähigkeit aufweist, wird erreicht, daß dem Prozessor mehr Wärme entzogen wird, als dies bei einem vergleichbaren Gerät mit herkömmlichem einwandigem Gehäuse der Fall wäre. Insbesondere bei einer Anpassung der inneren Gehäuseschale in ihrer Form und Anordnung derart, daß diese nahe an der Prozessoreinrichtung plaziert ist, wird ein erhöhter Wärmetransport von der Prozessoreinrichtung zur Flüssigkeit gewährleistet.

Obwohl durch die Erfindung zur Vereinfachung, Miniaturisierung oder Gewichtsreduzierung des Gerätes auf den Einsatz von Kühlrippen oder von kühlenden Lüftern verzichtet werden kann, schließt die Erfindung derartige zusätzliche Kühlrealisierungen für die Prozessoreinrichtung keinesfalls aus, sondern verstärkt sogar deren Wirkung.

Eine Weiterbildung der Erfindung sieht vor, daß die äußere Gehäuseschale zumindest teilweise transparent, insbesondere für sichtbares Licht durchlässig, ausgeführt ist. Diese Weiterbildung umfaßt auch semi-transparente bzw. für sichtbares Licht teildurchlässige äußere Gehäuseschalen. Vorteilhafterweise handelt es sich bei dem Material der äußeren Gehäuseschale zumindest teilweise um durchsichtigen Kunststoff oder Glas. Dadurch wird erreicht, daß die den Hohlraum füllende Flüssigkeit das Aussehen, insbesondere die Farbe des Gerätes beeinflußt oder sogar prägt. Dies ermöglicht zusammen mit einer Öffnung zur Befüllung des Hohlraumes mit verschiedenen Flüssigkeiten, welche insbesondere unterschiedliche Farben aufweisen können, wiederum eine Individualisierung des Gerätes mit einfachen Mitteln.

Die Erfindung ermöglicht somit mit einfachen Mitteln gleichzeitig eine Kühlung der Prozessoreinrichtung des Gerätes und eine Individualisierung des Gerätes.

Eine Ausführungsvariante der Erfindung sieht vor, daß die Flüssigkeit zumindest zwei Komponenten aufweist, die sich nicht homogen mischen. Eine andere Ausführungsvariante der Erfindung sieht vor, daß die Flüssigkeit zumindest zwei Komponenten aufeist, die unterschiedliche Viskositäten aufweisen. Dadurch wird durch einfache technische Mittel ein attraktiver ästhetischer Effekt erzielt, der insbesondere bei tragbaren Geräten nicht nur durch die Prozessorwärme sondern auch durch die Körperwärme des Benutzers aufgrund von Verwirbelungen noch verstärkt wird.

Der Erfindung liegt auch die Aufgabe zugrunde, ein Gehäuse, anzugeben, welches eine Individualisierung des Gehäuses mit einfachen Mitteln ermöglicht.

Diese Aufgabe wird durch die Merkmale des unabhängigen Anspruchs 5 gelöst. Vorteilhafte und zweckmäßige Weiterbildungen ergeben sich aus den abhängigen Ansprüchen.

Die Erfindung wird im Folgenden anhand eines bevorzugten Ausführungsbeispiels näher beschrieben, zu dessen Erläuterung nachfolgende Figur dient:

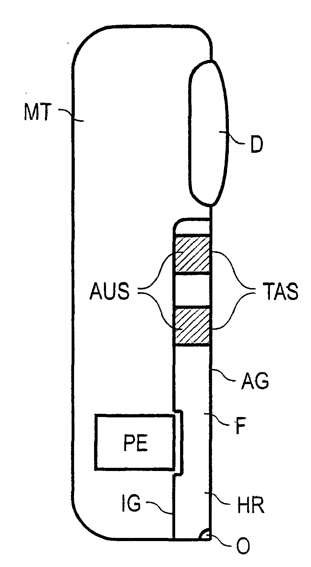

Figur 1: schematische seitliche Darstellung eines Mobiltelefons mit teilweise doppelwandigem Gehäuse.

Figur 1 zeigt ein Mobiltelefon MT, das zur Steuerung der wesentlichen Gerätefunktionen eine Prozessoreinrichtung PE, wie beispielsweise einen Micrcontroller aufweist. Das Gehäuse G des Mobiltelefons, das für Display D, Tastatur TAS, Schnittstelle etc. entsprechende Aussparungen AUS aufweist, ist zumindest auf der Vorderseite im unteren Teil des Mobiltelefons doppelwandig gebildet, wobei hier die innere Wand IG (Gehäuseschale) des Gehäuses in der Form an die Gestalt der Prozessoreinrichtung angepaßt ist. Zur Erzielung des gewünschten optischen Effektes ist die innere Wand zur äußeren Seite hin weiß gefärbt. Die äußere Wand AG des Gehäuses ist hier transparent für sichtbares Licht. Der durch das doppelwandige Gehäuse entstehende Hohlraum HR ist flüssigkeitsdicht abgeschlossen und weist zur Befüllung des Hohlraumes zumindest eine - durch ein Gewinde oder einen Rastverschluss flüssigkeitsdicht verschließbare - Öffnung O auf. Auch eine Vielzahl von Hohlräumen, die mit unterschiedlichen Flüssigkeiten gefüllt sein können, liegt im Rahmen der Erfindung.

Der entstehende Hohlraum ist mit einer Flüssigkeit F gefüllt, die zumindest zwei Komponenten unterschiedlicher Farbe enthält, die sich nicht homogen mischen, und welche unterschiedliche Viskositäten aufweisen.

Neben den oben erläuterten Ausführungsvarianten der Erfindung liegt eine Vielzahl weiterer Ausführungsvarianten im Rahmen der Erfindung, welche hier nicht weiter beschrieben werden, aber anhand des erläuterten Ausführungsbeispiels einfach in die Praxis umgesetzt werden können.

## Patentansprüche

1. Mobiltelefon (MT)
- mit einer elektronischen Schaltung, die Wärme durch Verlustleistung generiert, insbesondere einer Prozessoreinrichtung (PE),
- mit einer inneren Gehäuseschale (IG), die die elektronische Schaltung, insbesondere die Prozessoreinrichtung (PE), zumindest teilweise umgibt,
- mit einer äußeren Gehäuseschale (AG), die die innere Gehäuseschale (IG) zumindest teilweise umgibt,
- bei dem das Material der inneren Gehäuseschale (IG) und der äußeren Gehäuseschale (AG) zumindest teilweise flüssigkeitsdicht ist,
- bei dem die innere und die äußere Gehäuseschale derart angeordnet und ausgestaltet sind, daß sie einen Hohlraum (HR) bilden,
- bei dem die innere und die äußere Gehäuseschale derart miteinander verbunden sind, daß der Hohlraum (HR) flüssigkeitsdicht ist, und
- mit einer Flüssigkeit (F), welche den Hohlraum zumindest teilweise füllt.

2. Mobiltelefon nach Anspruch 1,
- bei dem die äußere Gehäuseschale zumindest teilweise transparent ist.

3. Mobiltelefon nach einem der vorhergehenden Ansprüche,
- bei dem der Hohlraum mindestens eine verschließbare Öffnung für die Flüssigkeit aufweist.

4. Mobiltelefon nach einem der vorhergehenden Ansprüche,
- bei dem die innere und die äußere Gehäuseschale einstückig gebildet sind.

## Revendications

1. Téléphone mobile (MT)
- avec un circuit électronique, qui génère de la chaleur par dissipation de puissance, en particulier un processeur (PE),
- avec une coque de boîtier intérieure (IG), qui entoure au moins partiellement le circuit électronique, en particulier le processeur (PE),
- avec une coque de boîtier extérieure (AG), qui entoure au moins partiellement la coque de boîtier intérieure (IG),
- sur lequel le matériau de la coque de boîtier intérieure (IG) et de la coque de boîtier extérieure (AG) est au moins en partie étanche aux liquides,
- sur lequel les coques de boîtier intérieure et extérieure sont disposées et conçues de telle sorte qu'elles forment une cavité (HR),
- sur lequel les coques de boîtier intérieure et extérieure sont reliées entre elles de telle sorte que la cavité (HR) est étanche aux liquides, et
- avec un liquide (F) qui remplit au moins partiellement la cavité.

2. Téléphone mobile selon la revendication 1,
- sur lequel la coque de boîtier extérieure est au moins partiellement transparente.

3. Téléphone mobile selon l'une quelconque des revendications précédentes,
- sur lequel la cavité présente au moins une ouverture pouvant être fermée pour le liquide.

4. Téléphone mobile selon l'une quelconque des revendications précédentes,
- sur lequel la coque de boîtier intérieure et la coque de boîtier extérieure sont formées d'une seule pièce.

## Claims

1. Mobile telephone (MT)
- with an electronic circuit that generates heat by dissipation, in particular a processor unit (PE),
- with an inner housing shell (IG) that at least partially encloses the electronic circuit, in particular the processor unit (PE),
- with an outer housing shell (AG) that at least partially encloses the inner housing shell (IG),
- in which the material of the inner housing shell (IG) and the outer housing shell (AG) is at least partially fluid-tight,
- in which the inner and outer housing shells are arranged and configured such that they form a hollow space (HR),
- in which the inner and outer housing shells are connected together such that the hollow space (HR) is fluid-tight, and
- with a fluid (F) that at least partially fills the hollow space.

2. Mobile telephone according to claim 1,
- in which the outer housing shell is at least partially transparent.

3. Mobile telephone according to one of the preceding claims,
- in which the hollow space has at least one sealable opening for the fluid.

4. Mobile telephone according to one of the preceding claims,
- in which the inner and outer housing shells are formed as a single piece.
